# EUROPEAN PATENT APPLICATION

(11) **EP 4 299 196 A1**
(43) Date of publication of application: **03.01.2024**
(21) Application number: 22759771.3
(22) Date of filing: 24.02.2022
(51) Int. Cl.: B05C 11/10, B05C 5/00, B41J 2/14

(54) **INKJET HEAD, METHOD FOR PRODUCING SAME, METHOD FOR PRODUCING SEMICONDUCTOR DEVICE USING SAME, AND PRINTING DEVICE**

(30) Priority: 24.02.2021 JP 2021027838
(71) Applicant: Yamagata University, Yamagata-shi, Yamagata 990-8560 (JP); SII Printek Inc., Mihama-ku Chiba-shi Chiba 261-8507 (JP)
(72) Inventor: SAKAI, Shinri, Yonezawa-shi, Yamagata 992-0119 (JP); BIZEN, Ryoichi, Yonezawa-shi, Yamagata 992-0119 (JP)
(74) Representative: Mewburn Ellis LLP
(86) International application number: PCT/JP2022/007763
(87) International publication number: WO 2022/181736

(57) **Abstract**

The present disclosure provides an inkjet head capable of continuously ejecting droplets at a high frequency even when an ink having high viscosity is used. The present is directed to an inkjet head characterized in that the inkjet head comprises a nozzle plate portion (10) on which a nozzle (11) for ejecting droplets is formed, a vibration plate (31,33) disposed opposite to an inlet of the nozzle (11), a weight (34) disposed in contact with the vibration plate (31), and an actuator (50) in contact with the weight (34), wherein the actuator (50) is driven by a drive signal to fly the weight (34) to eject ink in the ink chamber (60) formed between the nozzle plate portion (10) and the vibration plate (31,33) from the nozzle (11), and wherein a storage space (70) in which the actuator (50) is disposed is configured to be separated from the ink chamber (60) by the vibration plate (31,33).

## Description

### FIELD

The present invention relates to an inkjet head, a method for producing the same, a method for producing a semiconductor device using the same, and a printing device, and more particularly, to an inkjet head that ejects ink by vibration of an actuator, a method for producing the inkjet head, a method for producing a semiconductor device using the inkjet head, and a printing device.

### BACKGROUND

Conventionally, the inkjet technique for ejecting ink of a small amount of droplets has been used in an image forming device or the like which draws an image or the like on a paper surface with ink. In the image forming device, in order to form an image by impregnating ink on a paper surface, the ink used was adjusted to a component and viscosity suitable for impregnation on the paper surface. However, in recent years, there has been an increasing demand for applying inkjet technology to applications other than image formation on paper surfaces.

Examples of the application field of the inkjet technology include ink coating or overlapping on a resin or a metal, three-dimensional printing, and application of droplets containing functional fine particles. Droplets used in these applications tend to be more viscous than inks used in conventional inkjets.

In the conventional electrothermal conversion type inkjet technology, since droplets are heated and ejected by bubbles generated by liquid film boiling, it has been difficult to eject droplets of high viscosity. Further, in the conventional electromechanical conversion type inkjet technique, since the amount of displacement of the actuator is small, sufficient momentum cannot be transmitted to the droplets, and it is difficult to provide sufficient initial speed to the droplets ejected from the nozzle.

Therefore, in the electromechanical conversion type inkjet technology, it has been proposed to secure the amount of displacement of the vibrating body on which a flying object collides by transmitting the momentum of the actuator via the flying object, and to improve the ejection characteristics of the droplets (see, for example, PTL 1).

### [CITATION LIST]

### [PATENT LITERATURE]

[PTL 1] Japanese Unexamined Patent Publication No. H04-126254

### SUMMARY

### [TECHNICAL PROBLEM]

However, in the conventional technique of PTL 1, it is necessary to use a non-conductive wax as an ink, and there has been a problem that the application range is limited. Further, the efficiency of converting the electric energy applied to the actuator into the kinetic energy of the flying object is not sufficient, and it has been difficult to stably eject an ink having viscosity larger than about several mPa·s. Further, as the viscosity of the ink increases, it becomes difficult to supply the ink to the periphery of the nozzle, so that it has been difficult to continue ejecting the ink at a high frequency of about several kHz.

In view of the above, it is an object of the present invention to provide an inkjet head capable of continuously ejecting droplets at a high frequency even when an ink having high viscosity is used.

### [SOLUTION TO PROBLEM]

In order to solve the above problem, an inkjet head of the present invention comprises a nozzle plate portion on which a nozzle for ejecting droplets is formed, a vibration plate disposed opposite to an inlet of the nozzle, a weight disposed in contact with the vibration plate, and an actuator in contact with the weight, wherein the actuator is driven by a drive signal to fly the weight to eject ink in the ink chamber formed between the nozzle plate portion and the vibration plate from the nozzle, and wherein a storage space in which the actuator is disposed is configured to be separated from the ink chamber by the vibration plate.

In such an inkjet head of the present invention, various types of ink can be used since the storage space and the ink chamber are separated by the vibration plate, the ink is not filled in the storage space, and the actuator and the weight can be separated from the ink. Further, it is possible to reduce the loss of kinetic energy transmitted from the actuator to the vibration plate via the weight, and it is possible to continuously eject ink having high viscosity at a high frequency.

In one aspect of the present invention, the ink chamber comprises an ejection region comprising the inlet of the nozzle, and a reservoir region adjacent to the ejection region, and a gap between the nozzle plate portion and the vibration plate is smaller in the ejection region than in the reservoir region.

In one aspect of the present invention, the gap in the ejection region is in a range of 1 µm or more to 50 µm or less.

In one aspect of the present invention, a viscosity of the ink is in a range of 20 mPa·s or more. In this specification, the "viscosity" refers to a viscosity value at an ink temperature during operation of the inkjet head.

In one aspect of the present invention, the vibration plate is composed of a laminated structure of a beam-shaped spring portion and a thin plate portion, and the thin plate portion is composed of a flexible sheet.

In one aspect of the present invention, a portion of the spring portion facing the inlet of the nozzle is formed to be wide.

In one aspect of the present invention, the weight is spherical in shape, and the weight is fitted and positioned in a positioning portion provided in the spring portion.

In addition, in one aspect of the present invention, the weight is spherical in shape, and the weight is positioned on a base provided on a main surface of the thin plate portion on the storage space side.

In one aspect of the present invention, the spring portion comprises a projection portion on a main surface of the nozzle side so as to face the inlet of the nozzle, and the projection portion is configured to be insertable with a gap into the inlet of the nozzle.

In one aspect of the present invention, an ink supply hole is formed through the vibration plate, and the ink is supplied to the ink chamber via the ink supply hole.

In one aspect of the present invention, the inkjet head comprises a plurality of combinations of the actuator and the weight, and a spacer portion disposed between the nozzle plate portion and the vibration plate, and the spacer portion is provided between the plurality of adjacent actuators.

In one aspect of the present invention, the inkjet head comprises a support member for supporting the nozzle plate portion, wherein the support member is fixed to a laminated structure comprising the nozzle plate portion, the spacer portion, and the vibration plate.

In one aspect of the present invention, the support member is a non-driving portion integrally formed with the actuator.

In one aspect of the present invention, the inkjet head comprises a plurality of combinations of the actuator and the weight, and a spacer portion disposed between the nozzle plate portion and the vibration plate, wherein the vibration plate comprises a beam on a main surface of the thin plate portion on the storage space side, and a pillar on a main surface of the thin plate portion on the ink chamber side, the beam and the pillar are bonded to the thin plate portion between the plurality of adjacent weights and opposite each other with the thin plate portion interposed therebetween, and the pillar is also bonded to the nozzle plate portion.

In one aspect of the present invention, the spacer portion is composed of a cured product of a photosensitive film resist fixed to the nozzle plate portion and the vibration plate.

In one aspect of the present invention, the nozzle plate portion comprises a discharge flow path for the ink branched from the nozzle in the nozzle plate portion.

In order to solve the above problem, a printing device according to the present invention comprises the inkjet head according to any one of the above, and a drive control unit driving the inkjet head.

In order to solve the above problem, a method for producing a semiconductor device of the present invention is characterized in that a semiconductor is mounted on a substrate by printing a solvent-free ink using the printing device described above.

In order to solve the above problem, a method for producing the inkjet head of the present invention comprises disposing a photosensitive film resist having adhesiveness on the nozzle plate portion or the vibration plate, exposing and developing the photosensitive film resist to pattern the photosensitive film resist, disposing the vibration plate or the nozzle plate portion on the patterned photosensitive film resist, and post-baking a laminate comprising the nozzle plate portion, the photosensitive film resist, and the vibration plate to cure the photosensitive film resist to form the spacer portion to form a laminate in which the nozzle plate portion and the vibration plate are coupled with the spacer portion interposed therebetween.

In one aspect of the present invention, the method for producing the inkjet head comprises providing a temporary determination portion defining the gap between the nozzle plate portion and the vibration plate between the nozzle plate portion and the vibration plate, and removing the temporary determination portion after the inkjet head is assembled by disposing the actuator and the weight on the vibration plate.

In one aspect of the present invention, a height of the temporary determination portion is smaller than a height of the spacer portion.

### [ADVANTAGEOUS EFFECTS OF INVENTION]

According to the present invention, it is possible to provide an inkjet head capable of continuing ejection of droplets at a high frequency even if an ink having high viscosity is used.

### BRIEF DESCRIPTION OF DRAWINGS

FIG. 1 is a schematic cross-sectional drawing showing the structure of the inkjet head according to the first embodiment.
FIG. 2 is a schematic plan view showing the shape of the base portion in the spring portion 31, and FIG. 2(a) shows an example of a square, and FIG. 2(b) shows an example of a circle.
FIG. 3 is a schematic cross-sectional drawing showing the ink flow path in the inkjet head according to the first embodiment, and showing a direction orthogonal to the cross-sectional drawing of FIG. 1, and FIG. 3(a) shows a state before ink ejection, and FIG. 3(b) shows a state at the time of ink ejection.
FIG. 4 is an exploded perspective view showing the structure of the inkjet head according to the second embodiment.
FIG. 5 is a schematic plan view showing the relationship between the vibration plate 30 and the spacer portion 20 in the second embodiment.
FIG. 6 is a photograph showing an example of the vibration plate 30 in the second embodiment, and FIG. 6(a) shows a state in which the thin plate portion 33 is laminated on the spring portion 31, FIG. 6(b) shows a state in which the weight 34 is fixed to the vibration plate 30, and FIG. 6(c) shows an enlarged periphery of the weight 34.
FIG. 7 is a schematic plan view showing a structural example of the actuator substrate 51 in the second embodiment.
FIG. 8 is a schematic perspective view showing the relationship between the actuator substrate 51 and the vibration plate 30 in the second embodiment.
FIG. 9 is a drawing showing simulation results in the inkjet head according to the third embodiment, wherein FIG. 9(a) shows the flow velocity distribution of the ink around the vibration plate 30, and FIG. 9(b) shows the pressure distribution of the ink around the vibration plate 30.
FIG. 10 is a drawing showing the simulation results obtained by changing the gap between the vibration plate 30 and the nozzle plate portion 10 in the inkjet head according to the third embodiment, and showing the flow velocity distribution of the ink around the vibration plate 30.
FIG. 11 is a graph showing ink ejection results in the inkjet head according to the third embodiment, wherein FIG. 11(a) shows the ink ejection speed, and FIG. 11(b) shows the ink ejection volume.
FIG. 12 is a schematic cross-sectional drawing showing the structure of the inkjet head according to the fourth embodiment.
FIG. 13 is a schematic cross-sectional drawing showing the structure of the inkjet head according to the fifth embodiment.
FIG. 14 is a schematic cross-sectional drawing showing the structure of the inkjet head according to the sixth embodiment.
FIG. 15 is a schematic cross-sectional drawing showing the structure of the inkjet head according to the seventh embodiment.
FIG. 16 is a schematic cross-sectional drawing showing the structure of the inkjet head according to the eighth embodiment.
FIG. 17 is a schematic cross-sectional drawing showing the structure of the inkjet head according to the ninth embodiment.
FIG. 18 is a schematic cross-sectional drawing showing the structure of the inkjet head according to the tenth embodiment.
FIG. 19 is a schematic plan view of the plate constituting the beam in the tenth embodiment.
FIG. 20 is a schematic cross-sectional drawing showing the structure of the inkjet head according to the twelfth embodiment.
FIG. 21 is a schematic cross-sectional drawing showing the structure of the inkjet head according to the thirteenth embodiment.

### DESCRIPTION OF EMBODIMENTS

### (First Embodiment)

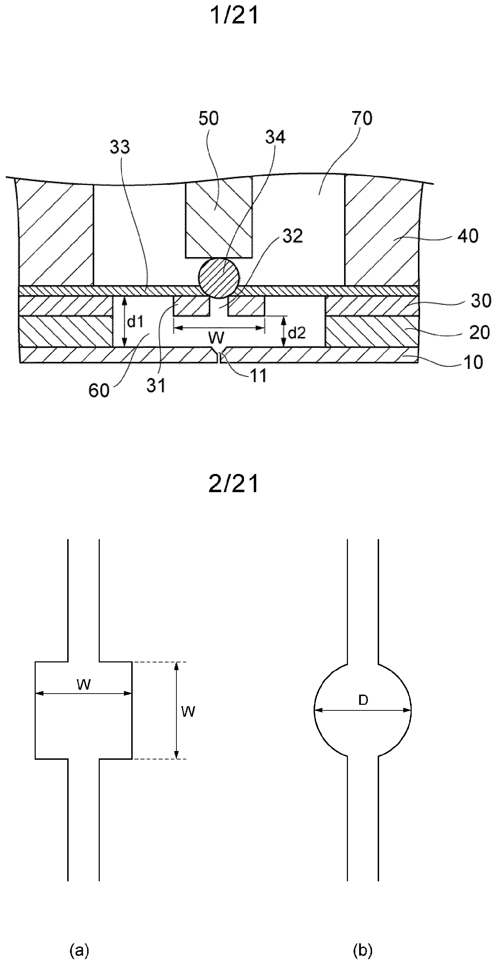

Hereinafter, embodiments of the present invention will be described in detail with reference to the drawings. The same or equivalent components, members, and processes shown in the drawings will be denoted by the same reference numerals, and redundant description will be omitted as appropriate. FIG. 1 is a schematic cross-sectional drawing showing the structure of the inkjet head according to the present embodiment.

As shown in FIG. 1, the inkjet head of the present embodiment comprises a nozzle plate portion 10, a spacer portion 20, a vibration plate 30, a case portion 40, and an actuator 50. In addition, a nozzle 11 is formed in the nozzle plate portion 10. Further, the vibration plate 30 comprises a spring portion 31, a positioning portion 32, and a thin plate portion 33, and a weight 34 is disposed on the positioning portion 32. Further, an ink chamber 60 is formed between the nozzle plate portion 10 and the thin plate portion 33 of the vibration plate 30, and a storage space 70 is configured on the actuator 50 side of the thin plate portion 33 of the vibration plate 30.

The nozzle plate portion 10 is a member that separates the ink chamber 60 filled with ink from the ink ejection destination. A nozzle 11, which is a hole penetrating from the ink chamber 60 side to the outside, is formed in the nozzle plate portion 10. In the example shown in FIG. 1, an example in which the nozzle plate portion 10 is configured as a substantially plate-shaped member having a uniform thickness is shown, but different thickness portions, projections, concave portions, and the like may be formed as necessary. Further, although FIG. 1 shows a single plate-shaped member as the nozzle plate portion 10, a laminated structure of a plate-shaped member in which the nozzle 11 is formed and a nozzle communication passage substrate connected to the nozzle 11 may be used as the nozzle plate portion 10.

The nozzle 11 is a through-hole formed in the nozzle plate portion 10, and ink filled in the ink chamber 60 is ejected from the ink chamber 60 to the outside via the nozzle 11. The shape of the nozzle 11 is not limited, but in the example shown in FIG. 1, the nozzle has a truncated conical shape whose diameter is widened at the inlet side of the nozzle 11 in the ink chamber 60, and has a cylindrical shape with the same diameter at the outlet side at the outside. As a specific example, the inlet side has an apex angle in the range of 20 to 60 degrees, and the outlet side has a diameter in the range of 0.015 to 0.1 mm. By using the nozzle 11 with a shape of a combination of a truncated conical shape and a cylinder, it is possible to reduce the fluid resistance when ink passes through the nozzle 11 even for ink with high viscosity, and to efficiently eject the droplets.

The spacer portion 20 is a substantially plate-shaped member having an opening portion to be described later formed thereon, and is disposed between the nozzle plate portion 10 and the vibration plate 30 to maintain a gap between the nozzle plate portion 10 and the vibration plate 30. As shown in FIG. 1, a nozzle 11 is positioned in the opening of the spacer portion 20, and the opening portion constitutes a part of the ink chamber 60. Further, the lower surface of the spacer portion 20 is in contact with the nozzle plate portion 10 and fixed by an adhesive or the like, and the upper surface thereof is in contact with the vibration plate 30 and fixed by an adhesive or the like.

The vibration plate 30 is a member that is disposed on the spacer portion 20 and separates the ink chamber 60 and the storage space 70, and vibrates in the ink chamber 60 with the movement of the weight 34. In the example shown in FIG. 1, the vibration plate 30 comprises a spring portion 31 which is a metal beam-shaped member, a positioning portion 32 formed in the spring portion 31, and a thin plate portion 33 composed of a flexible sheet. Since the vibration plate 30 separates the ink chamber 60 from the storage space 70, even if ink is filled in the ink chamber 60, the ink does not reach the storage space 70 side, and the weight 34 and the actuator 50 disposed in the storage space 70 do not contact the ink. Thus, it becomes possible to employ an ink material having conductivity or an ink containing functional fine particles, and the degree of freedom in selecting an ink material is improved. Further, since the movement of the weight 34 and the actuator 50 is not inhibited by ink, even if an ink material having high viscosity is used, the energy applied to the actuator 50 is efficiently transmitted to the weight 34 and the vibration plate 30, and droplets can be efficiently ejected from the nozzle 11.

The spring portion 31 is a beam-shaped elastic member integrally formed with the metal frame body, and performs a movement operation in the direction of the ink chamber 60 accompanying the movement of the weight 34 flicked by the actuator 50, and a movement operation in the direction of the storage space 70 by the elastic force. In the spring portion 31, a positioning portion 32 is formed at a position facing the nozzle 11, and the weight 34 is fitted and positioned in the positioning portion 32. As described later, the shape of the spring portion 31 may include a flat, wide base portion to which the weight 34 contacts and a double-supported beam portion formed by extending from both sides of the base portion, but may be a cantilever beam structure or other structure as long as it has a structure capable of restoring the position of the weight 34 due to elasticity.

FIG. 2 is a schematic plan view showing the shape of the base portion in the spring portion 31, FIG. 2(a) shows an example of a square, and FIG. 2(b) shows an example of a circle. In the example shown in FIG. 2(a), the base portion has a square shape having a width W and a length W, and in the example shown in FIG. 2(b), the base portion has a circular shape with a diameter D. In the examples shown in FIG. 2(a) and (b), the widths of the base portions are W and D, and are formed wider than the beam portion. Here, although a square and a circle are shown, they may be rectangular or oval. As will be described later, when a plurality of nozzles 11 and a plurality of spring portions 31 are provided, a circle is preferably used as the base portion in order to suppress interference with the adjacent nozzles 11 and to enhance ejection efficiency. In addition, when a rectangle is used as the base portion, it is preferable to form a fillet having a large thickness at a corner portion of the rectangle, and to prevent occurrence of cracks in the thin plate portion 33 due to stress concentration on the corner portion.

The positioning portion 32 is a hole formed in the spring portion 31 at a position facing the nozzle 11, and the diameter of the hole is smaller than the diameter of the weight 34, and the weight 34 is positioned by being fitted in contact with the hole. In FIG. 1, a through-hole is shown as the positioning portion 32, but the structure is not limited as long as the weight 34 can be positioned, and may be a concave portion (a blind hole not penetrating) or a convex portion (for example, a ridge-shaped convex portion protruding in a circular shape so that the weight 34 is positioned).

The thin plate portion 33 is a flexible sheet-shaped member laminated and bonded to the spring portion 31 and the frame body of the vibration plate 30. Further, the thin plate portion 33 is bonded to the spring portion 31 and the frame body of the vibration plate 30, and is sealed between the spring portion and the frame body. Since the thin plate portion 33 is disposed between the ink chamber 60 and the storage space 70 and is sealed, the ink chamber 60 and the storage space 70 are separated from each other. Further, since the thin plate portion 33 has flexibility, it deforms between the ink chamber 60 and the storage space 70 following the movement of the weight 34 and the spring portion 31. In the example shown in FIG. 1, the opening having substantially the same diameter as the positioning portion 32 is formed at the position corresponding to the positioning portion 32 in the thin plate portion 33, but the opening need not be formed if the weight 34 can be positioned by fitting the weight 34 to the positioning portion 32.

The weight 34 is a substantially spherical member disposed between the actuator 50 and the vibration plate 30, and is fitted and positioned in contact with the positioning portion 32. In a state in which the inkjet head is not driven, the weight 34 abuts on the actuator 50 and is biased toward the ink chamber 60 at the tip of the actuator 50, and is held at a position in which a balance with the restoring force by the spring portion 31 is maintained. In the example shown in FIG. 1, the weight 34 is fixed to the opening of the thin plate portion 33 and the positioning portion 32 by using an adhesive, but when the weight 34 does not come off from the positioning portion by balance between the bias by the actuator 50 and the restoring force of the spring portion 31, it is not necessary to fix it with an adhesive. Here, a spherical shape is shown as the weight 34, but the shape is not limited as long as the object flies due to the momentum caused by the deformation of the actuator 50, and may be, for example, a block shape of a rectangular parallelepiped.

The case portion 40 is a member that constitutes an outer shape of the inkjet head and holds the vibration plate 30, the spacer portion 20, and the nozzle plate portion 10. In addition, a storage space 70 is formed inside the case portion 40, and the case portion 40 positions and holds the actuator 50. As will be described later, an ink flow path is formed in the case portion 40, and ink is supplied from the outside into the ink chamber 60 via the flow path.

The actuator 50 is driven by an external drive signal, deforms when a voltage is applied, and transmits kinetic energy to the weight 34 in contact with the tip to fly in the direction of the nozzle 11. As the actuator 50, a conventionally known material and a structure can be used, and examples thereof include a piezoelectric material using lead zirconate titanate (PZT: PbTiO₃-PZrO₃ based solid solution). As described above, the tip of the actuator 50 is in contact with the weight 34, and biases the weight 34 and the spring portion 31 toward the ink chamber 60 in a state in which the actuator 50 is not driven. Here, the amount of pressing the weight 34 and the spring portion 31 by biasing them toward the ink chamber 60 is not limited, and is set by the elastic constant of the spring portion 31 and the mass of the weight 34, but as an example, it is preferable that the amount is about several µm to tens of µm from a position where no external force is applied to the spring portion 31. Although an electrode for applying a voltage is formed on the actuator 50 (not shown), since the storage space 70 is separated from the ink chamber 60 by the vibration plate 30 the ink does not contact the actuator 50, the operation of the actuator 50 is not hindered even if a conductive material is used for the ink.

The ink chamber 60 is a space composed of the nozzle plate portion 10, the spacer portion 20, and the vibration plate 30, and is filled with ink through an ink flow path and an ink supply hole, which will be described later. Further, the region comprising the inlet of the nozzle 11 constitutes an ejection region, and the other region adjacent to the ejection region in the ink chamber 60 is a reservoir region. In the example shown in FIG. 1, the range of the width W in which the spring portion 31 is provided is the ejection region, and the peripheral region thereof is the reservoir region. The distance (gap) between the nozzle plate portion 10 and the vibration plate 30 in the reservoir region is the distance d1 between the nozzle plate portion 10 and the thin plate portion 33, and the distance (gap) between the nozzle plate portion 10 and the vibration plate 30 in the ejection region is the distance d2 between the nozzle plate portion 10 and the spring portion 31. At this time, the distance d2 is smaller than the distance d1. The distance d1 and the distance d2 are not limited, but in order to efficiently eject ink having high viscosity, the distance d2 is preferably in a range of 1 µm or more to 50 µm or less, and more preferably in a range of 5 µm or more to 30 µm or less.

When the distance between the flat plates facing at the distance d2 is reduced and the liquid filled between the flat plates is subjected to compression, the pressure acting on the flat plate is proportional to the fourth power of the dimension of the flat plate, which is, for example, the width W of one side if it is a square, and the diameter D if it is a circle, and is inversely proportional to the third power of the distance d2. In the same manner, the resistance of the ejection region is proportional to the square of the dimension of the flat plate and is inversely proportional to the cube of the distance d2. Further, the volume of the ink flowing out from the ejection region to the nozzle 11 and the reservoir region by the displacement of the vibration plate 30 is proportional to the square of the dimension of the flat plate. Making d1 larger than d2 is effective in increasing the ejection frequency by increasing the ink supply from the reservoir region to the ejection region, and increasing the ejection efficiency, such as an improvement in the ejection speed, by reducing the suppression of the vibration plate displacement by the pressure in the reservoir region. The distance d1 is preferably equal to or greater than twice the distance d2.

In the ink chamber 60, since the distance d2 of the ejection region is smaller than the distance d1 of the reservoir region, when pressure is applied to the ink in the ink chamber 60 by the movement of the weight 34 and the spring portion 31, the ink in the ejection region is suppressed from expanding in the reservoir region direction. This is because the smaller the distance d2, the larger the fluid resistance when the ink moves in the lateral direction in the ink chamber 60. Thus, the movement of the weight 34 is efficiently transmitted to the ink as a movement from the spring portion 31 toward the nozzle 11, and even if the ink has high viscosity, for example, 20 mPa·s or more, the speed at which the droplets are ejected can be improved. The viscosity of the ink is not limited to an upper limit, but is preferably 1 Pa·s or less, more preferably 200 mPa·s or less in order to satisfactorily eject the droplets. Further, since the distance d1 of the reservoir region is larger than the distance d2 of the ejection region, the ink can be quickly supplied from the outside into the ink chamber 60, and it is possible to prevent the ink from being insufficient even when the droplets are ejected at a high frequency.

If the width W of the ejection region in the ink chamber 60 is too large, it is difficult for the ink to flow from the reservoir region to the vicinity of the nozzle 11 in the ejection region, and it becomes difficult to eject the droplets from the nozzle 11 at a high frequency. Further, if the width W of the ejection region is too small, even if pressure is applied to the ink in the ejection region by the movement of the weight 34 and the spring portion 31, the fluid resistance in the lateral direction is insufficient, and the ink moving to the reservoir region increases, making it difficult to secure the volume and the speed of the droplets ejected from the nozzle 11 to the outside. The width W of the ejection region is preferably in a range of 200 µm or more to 2 mm or less, and more preferably in a range of 200 µm or more to 1 mm or less.

The storage space 70 is a space configured inside the case portion 40, and accommodates the weight 34 and the actuator 50 therein. As described above, the storage space 70 is separated from the ink chamber 60 by the thin plate portion 33 of the vibration plate 30, and the ink is not filled in the storage space 70, and a space is secured around the actuator 50 and the weight 34.

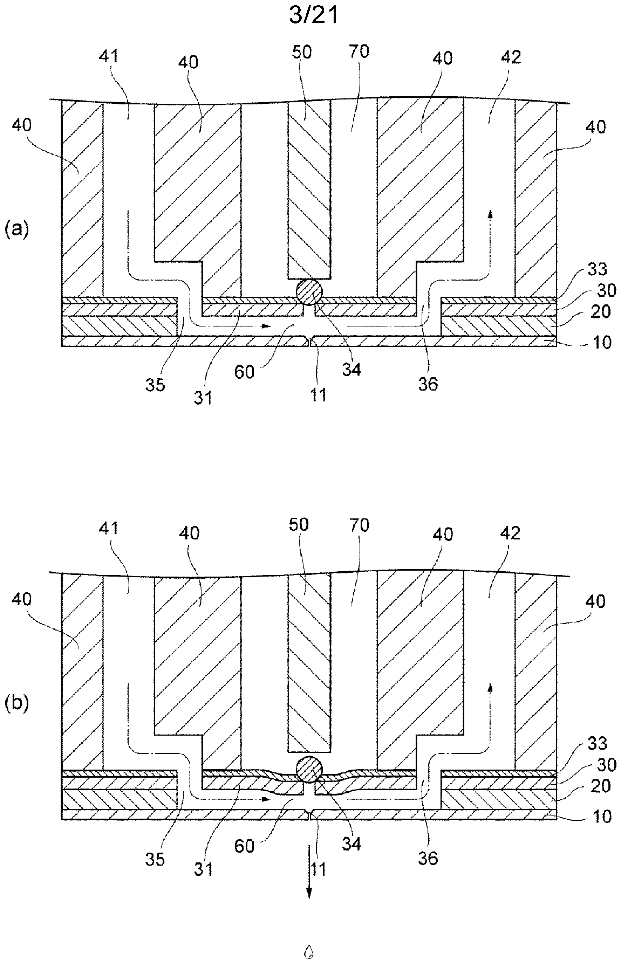

FIG. 3 is a schematic cross-sectional drawing showing an ink flow path in the inkjet head according to the present embodiment, showing a direction orthogonal to the cross-sectional drawing shown in FIG. 1, and FIG. 3(a) shows a state before ink ejection, and FIG. 3(b) shows a state at the time of ink ejection. As shown in FIG. 3(a) and FIG. 3(b), ink flow paths 41 and 42 are formed in the case portion 40, and an ink supply hole 35 and an ink discharge hole 36 are formed in the vibration plate 30 at positions corresponding to the ink flow paths 41 and 42. When ink is supplied from the outside of the case portion 40 to the ink flow path 41, the ink reaches the ink chamber 60 via the ink flow path 41 and the ink supply hole 35. Since the ink supply from the outside to the ink flow path 41 is continuously performed, the ink filled in the ink chamber 60 is discharged to the outside via the ink discharge hole 36 and the ink flow path 42 and collected. The collected ink may be reused by the circulation system and supplied to the ink flow path 41.

As shown in FIG. 3(b), when the actuator 50 is driven by the drive signal and a voltage is applied, the actuator 50 is deformed by the piezoelectric effect, and the weight 34 that has been in contact with the tip of the actuator 50 is flicked in the direction of the nozzle 11. The weight 34 flicked by the actuator 50 elastically deforms the thin plate portion 33 and the spring portion 31 and pushes them into the ink chamber 60. At this time, in the ejection region comprising the inlet of the nozzle 11, a pressure that generates a flow in the external direction (downward in the drawing) is applied to the ink, and droplets of the ink that have passed through the nozzle 11 are ejected. The spring portion 31 is restored to its original shape by an elastic force, and the weight 34 is again brought into contact with the tip of the actuator 50 to return to the state of FIG. 3(a). While the actuator 50 is driven by the drive signal, the ejection operation shown in FIG. 3(a) and FIG. 3(b) is repeated, and droplets of ink are repeatedly ejected from the nozzles 11 of the inkjet head.

As described above, in the inkjet head according to the present embodiment, the storage space 70 and the ink chamber 60 are separated from each other by the vibration plate 30, and the actuator 50 and the weight 34 can be separated from the ink without filling the ink in the storage space 70, so that various types of ink can be used, and the degree of freedom in selecting the ink material is improved. Further, it is possible to reduce the loss of kinetic energy transmitted from the actuator 50 to the vibration plate 30 via the weight 34, and it is possible to continuously eject ink having high viscosity at a high frequency.

Further, the ink chamber 60 comprises the ejection region comprising the inlet of the nozzle 11 and the reservoir region adjacent to the ejection region, and the gap between the nozzle plate portion 10 and the vibration plate 30 is smaller in the distance d2 in the ejection region than the distance d1 in the reservoir region, so that even an ink having a high viscosity of 20 mPa·s or more, for example, an ink having high viscosity, such as 20 mPa·s or more and 1 Pa·s or less, can improve the speed of ejecting droplets.

### (Second Embodiment)

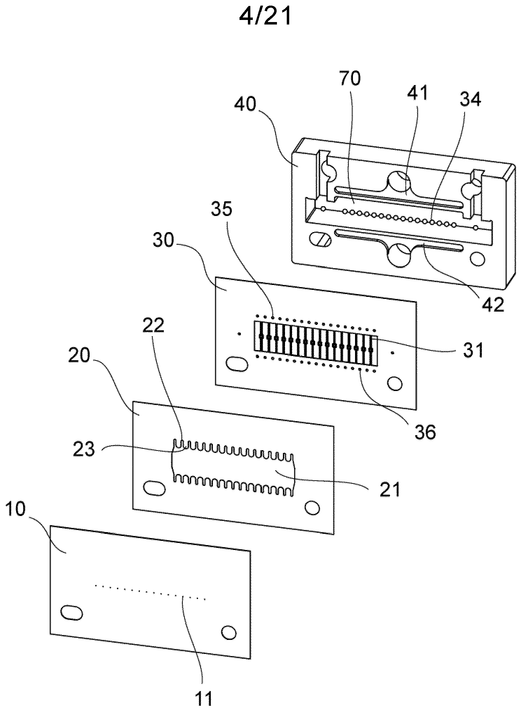

Next, a second embodiment of the present invention will be described. Description of contents overlapping with those of the first embodiment will be omitted. FIG. 4 is an exploded perspective view showing the structure of the inkjet head according to the present embodiment. As shown in FIG. 4, the inkjet head has a structure in which a nozzle plate portion 10, a spacer portion 20, a vibration plate 30, and a case portion 40 are combined. In FIG. 4, the thin plate portion 33 is bonded to the surface of the vibration plate 30 facing the case portion 40, and is not shown in the drawing. In the present embodiment, it is different from the first embodiment in that a plurality of nozzles 11 are provided in the nozzle plate portion 10, and a plurality of spring portions 31, weights 34, ink supply holes 35, ink discharge holes 36, and actuators 50 (not shown) are provided correspondingly.

A plurality of nozzles 11 are formed in a linear arrangement at equal intervals on the nozzle plate portion 10, and double-supported beam-shaped spring portions 31 are formed on the vibration plate 30 at positions opposed to each nozzle 11. In addition, weights 34 are arranged in combination in each of the spring portions 31. In FIG. 4, the weights 34 are described on the side of the case portion 40 in a state of being separated from the vibration plate 30, but in the same manner as in the first embodiment, the weights 34 are positioned and fixed by being fitted into the positioning portions 32 of the spring portions 31. In addition, a plurality of ink supply holes 35 and ink discharge holes 36 are formed in the vibration plate 30 in the vicinity of the roots of the beam-shaped portions in the spring portions 31.

The spacer portion 20 is formed with an opening portion 21 so as to comprise a plurality of spring portions 31, and a plurality of cut portions 22 and tongue-shaped portions 23 are alternately formed on the upper and lower sides of the opening portion 21. The cut portions 22 are portions in which the opening portion 21 is extended to the plurality of ink supply holes 35 and the ink discharge holes 36. The tongue-shaped portions 23 are portions formed by extending a part of the spacer portion 20 so as to cover the roots of the beam-shaped portions in the plurality of spring portions 31.

The ink flow paths 41 and 42 of the case portion 40 comprise a cylindrical through-hole which is an inflow and outflow path of ink to and from the outside, and an enlarged portion which is formed so as to be in communication with the through-hole so as to cover the plurality of ink supply holes 35 and the ink discharge holes 36. Therefore, in the inkjet head of the present embodiment, the ink supplied from the through hole of the ink flow path 41 reaches the plurality of ink supply holes 35 via the enlarged portion, and is filled from the ink supply holes 35 into the opening portion 21 constituting the ink chamber 60 via the cut portions 22. The ink in the ink chamber 60 reaches the cut portions 22 on the opposite side via the opening portion 21, and is discharged from the ink discharge holes 36 via the enlarged portion and the through hole of the ink flow path 42 and is collected.

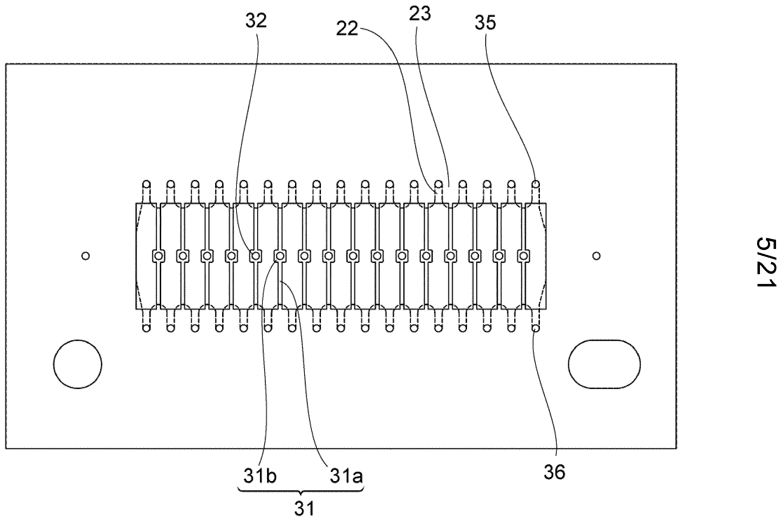

FIG. 5 is a schematic plan view showing the relationship between the vibration plate 30 and the spacer portion 20 in the present embodiment. The region drawn with a broken line in the drawing indicates the outer shape of the opening portion 21 in the spacer portion 20. As shown in FIG. 5, when the spacer portion 20 and the vibration plate 30 are overlapped, the ink supply holes 35 and the ink discharge holes 36 are positioned at the tips of the cut portions 22. Therefore, the ink that has reached the ink supply holes 35 from the ink flow path 41 is supplied to the reservoir region and the ejection region of the ink chamber 60 via the inside of the cut portions 22. Further, the ink filled in the ink chamber 60 reaches the ink discharge holes 36 via the cut portions 22, and is discharged from the ink flow path 42.

Further, the spring portion 31 comprises a linear beam portion 31a and a wide flat base portion 31b, and a positioning portion 32 is formed on the base portion 31b. The beam portions 31a extend in the vertical direction in the drawing from both sides of the base portion 3 1b and are integrally formed with the frame body. When the portion where the beam portion 31a is connected to the frame body is defined as a root, the tongue-shaped portion 23 of the spacer portion 20 is formed so as to protrude into the inside of the frame body, and is superposed on the root of the beam portion 31a. Since the vibration plate 30 and the spacer portion 20 are fixed by an adhesive, the tongue-shaped portion 23 is also bonded to the root portion of the beam portion 31a, and reinforces the root portions of the individual spring portions 31, respectively. Due to the reinforcement at the tongue portion 23, even when the adjacent spring portion 31 is elastically deformed, it is possible to prevent deformation from being transmitted to the root portion and unexpected deformation from occurring in the spring portion 31.

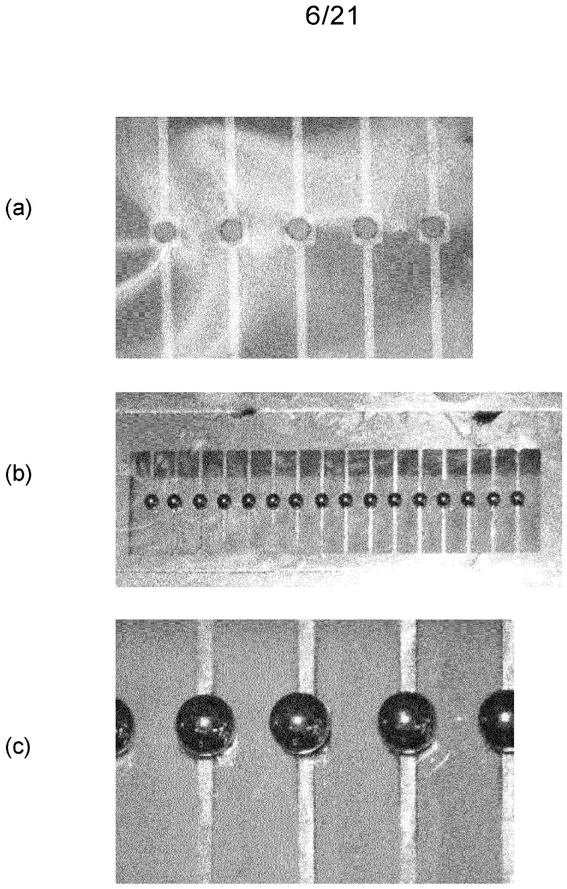

FIG. 6 is a photograph showing an example of the vibration plate 30 in the present embodiment. FIG. 6(a) shows a state in which the thin plate portion 33 is laminated on the spring portion 31, FIG. 6(b) shows a state in which the weight 34 is fixed to the vibration plate 30, and FIG. 6(c) shows an enlarged periphery of the weight 34.

In the example shown in FIG. 6(a), the thin plate portion 33 is composed of a transparent film, and a state in which light is partially reflected on the surface of the thin plate portion 33 is shown. The transparent film is preferably a film of polyimide or a film of polyphenylene sulfide (PPS). The thin plate portion 33 is disposed on the beam portions 31a and the base portions 31b constituting the spring portions 31, and openings are formed in the thin plate portion 33 at the positioning portions 32 of the base portions 31b. At the opening of the thin plate portion 33, an adhesive is applied along the circumference, and the base portion 31b and the thin plate portion 33 are fixed.

In the examples shown in FIG. 6(b) and FIG. 6(c), the weights 34 are respectively mounted on the base portions 31b and fixed by an adhesive. As shown in FIG. 6(b), the thin plate portion 33 is overlapped so as to cover not only the spring portions 31 but also the frame body to which the beam portions 31a are connected, and the frame body and the thin plate portion 33 are also fixed by an adhesive.

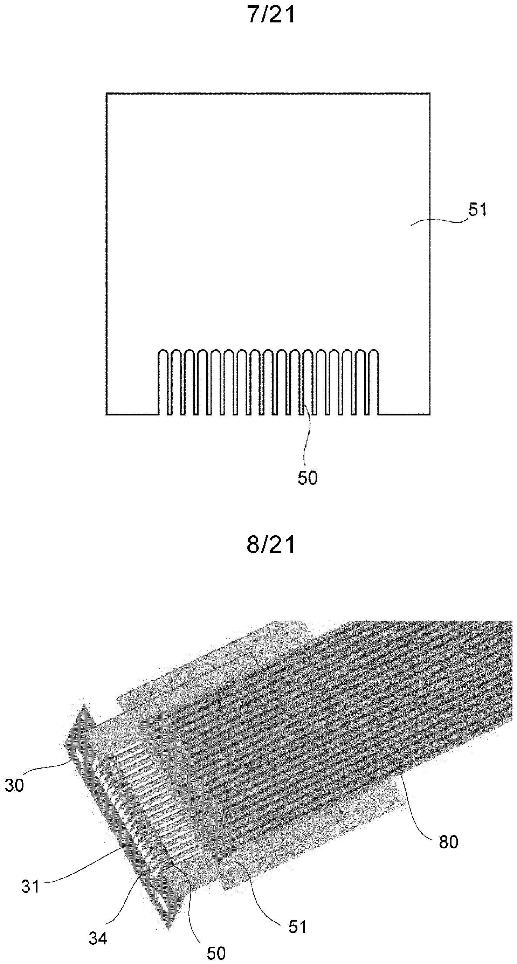

FIG. 7 is a schematic plan view showing a structural example of the actuator substrate 51 in the present embodiment. As shown in FIG. 7, the actuator substrate 51 is a plate-shaped member obtained by forming a piezoelectric material, such as PZT, into a substantially rectangular shape, and a plurality of actuators 50 are formed in a comb-tooth shape along one side. Although not shown in FIG. 7, electrodes are formed on both surfaces of the actuator 50, and the actuator 50 performs an expansion and contraction operation in the longitudinal direction of the comb teeth by applying a voltage to the electrodes on both surfaces. The interval between the comb-shaped actuators 50 is equal to the interval between the spring portions 31 shown in FIG. 4 to FIG. 6, and is arranged so that the tips of the actuators 50 contact the weights 34, respectively. Each of the plurality of actuators 50 corresponds to an actuator in the present invention. The size and shape of the actuator substrate 51 are not limited, and examples thereof include a PZT of 0.3 mm thickness with a 5mm long actuator 50 formed at 0.5mm intervals.

FIG. 8 is a schematic perspective view showing the relationship between the actuator substrate 51 and the vibration plate 30 in the present embodiment. In FIG. 8, the nozzle plate portion 10, the spacer portion 20, the thin plate portion 33, and the case portion 40 are not shown in the drawing for simplicity, but as shown in FIG. 4, they are disposed and bonded on the front and rear surfaces of the vibration plate 30, respectively. As shown in FIG. 8, a weight 34 is bonded and fixed to each of the spring portions 31 of the vibration plate 30, and the tips of the plurality of actuators 50 formed on the actuator substrate 51 are disposed so as to be in contact with the weights 34.

The actuator substrate 51 is biased so that the tip of the actuator 50 abuts on the weight 34 and pushes the weight 34 toward the spring portion 31. The actuator substrate 51 is fixed to the case portion 40 with an adhesive after determining the amount of pushing the weight 34 and the relative angle with respect to the vibration plate 30. Further, a flexible cable 80 is mounted on one surface side of the actuator substrate 51, and each wiring of the flexible cable 80 is connected to an individual electrode of the actuator 50 and a common electrode common to the plurality of actuators 50 by an anisotropic conductive film.

When a drive signal is transmitted from the outside of the inkjet head via the flexible cable 80, a voltage is applied from both surfaces to each of the actuators 50 via the wiring of the flexible cable 80, the anisotropic conductive film, and the electrodes, and the actuators 50 individually perform an expansion and contraction operation. With the extension operation of the actuator 50, the kinetic energy is transferred to the weight 34 in contact with the tip of the actuator 50, the weight 34 is flicked toward the spring portion 31, and the ink in the ink chamber 60 is ejected from the nozzle 11. Therefore, in the inkjet head of the present embodiment, it is possible to individually eject droplets of ink from the plurality of nozzles 11 and perform a desired ink application operation.

Further, as shown in FIG. 8, both sides of an edge of the actuator substrate 51 on which the actuator 50 is formed have the tips bonded to the frame of the vibration plate 30, and the vibration plate 30, the spacer portion 20, and the nozzle plate portion 10 are held on both sides of the actuator substrate 51. Here, both sides of the actuator substrate 51 support the nozzle plate portion 10 and correspond to the supporting member in the present invention. Both sides of the actuator substrate 51 are integrally formed of the same piezoelectric material as the actuator 50, but since no electrode is formed, they are non-driving portions which do not perform an expansion and contraction operation due to the piezoelectric effect. By holding the frame of the vibration plate 30 using the non-driving portions which are both sides of the actuator substrate 51, the vibration plate 30 can be held as close to the actuator 50 and the spring portion 31 as possible. Thus, it is possible to suppress deformation of the frame body due to the expansion and contraction operation of the actuator 50, to accurately control the amount of variation of the individual actuator 50 and the spring portion 31, and to accurately control the ejection of the ink droplets.

As described above, in the inkjet head of the present embodiment, the plurality of actuators 50 individually apply kinetic energy to the plurality of weights 34 and the spring portions 31, so that ink droplets can be ejected from the plurality of nozzles 11. Further, by holding the frame body of the vibration plate 30 at the non-driving portion of the actuator substrate 51, it is possible to suppress the deformation of the frame body and accurately control the ejection of the ink droplets.

### (Third Embodiment)

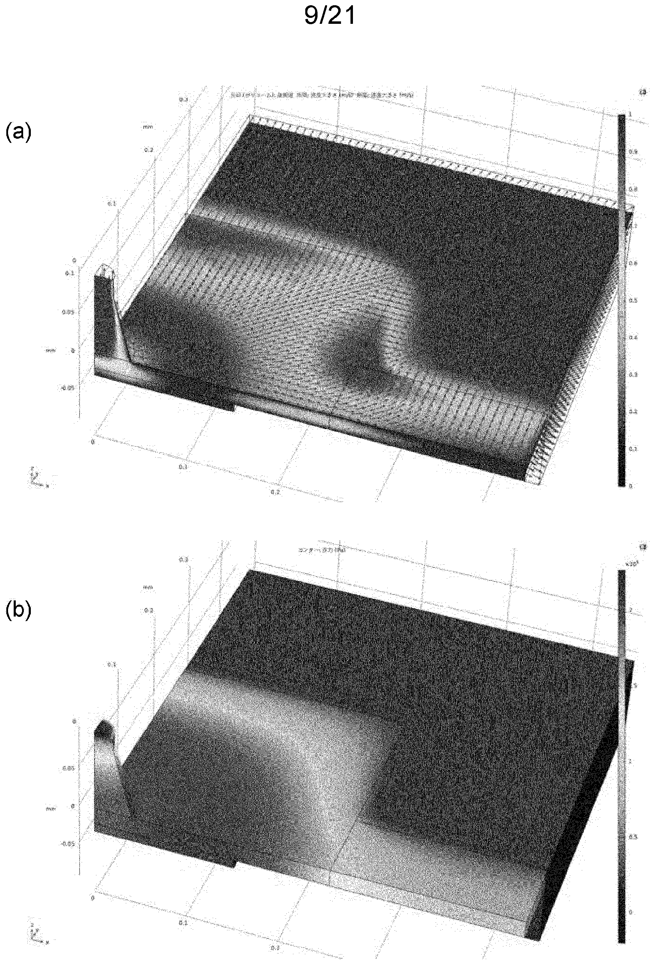

Next, a third embodiment of the present invention will be described. Description of contents overlapping with those of the first embodiment will be omitted. FIG. 9 is a drawing showing simulation results in the inkjet head according to the present embodiment, wherein FIG. 9(a) shows the flow velocity distribution of the ink around the vibration plate 30, and FIG. 9(b) shows the pressure distribution of the ink around the vibration plate 30. The Z-axis direction in FIG. 9(a) and FIG. 9(b) is a direction from the vibration plate 30 toward the nozzle plate portion 10, and is a direction (downward direction) in which droplets are ejected in FIG. 1.

The simulation results shown in FIG. 9(a) and (b) show the results of dividing the spring portion 31 into one fourth in plan view and performing the laminar steady flow calculation. The conditions of the simulation are as follows: the width of the beam portion 31a was 0.15 mm, the width and length of the base portion 31b were 0.5 mm respectively, and the diameter of the nozzle 11 was 40 µm, as the shape of the spring portion 31. Further, the distance d2 between the nozzle plate portion 10 and the spring portion 31 in the ejection region was 20 µm, the viscosity of the ink was 100 mPa s, the density of the ink was 1000 kg/m³, and the base portion 31b was moved toward the nozzle plate portion 10 at 0.1 m/s. Further, the thickness of the spring portion 31 was 75 µm, and the distance d1 between the nozzle plate portion 10 and the thin plate portion 33 in the reservoir region was 95 µm.

In FIG. 9(a), a minute arrow indicates the moving direction of the ink in the ink chamber 60, and the shade of the color indicates the flow rate of the ink. As shown in FIG. 9(a), in the nozzle 11, ink flows at a large flow rate upward (outward from the nozzle 11) in the drawing. In addition, a region having a small flow velocity is present in an annular shape around the nozzle 11, and in the vicinity of the outer periphery of the base portion 31b, which is the outer side of the region, ink flows out from the ejection region toward the reservoir region. In the pressure distribution shown in FIG. 9(b), the pressure in the vicinity of the center of the base portion 3 1b is high about the nozzle 11, and the pressure is low in the vicinity of the outer periphery of the base portion 31b.

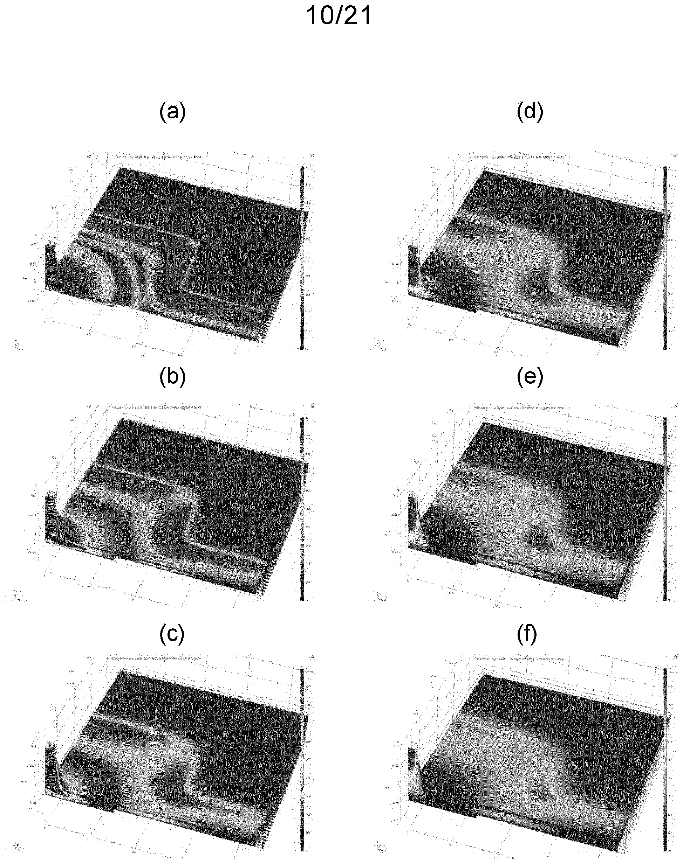

FIG. 10 is a drawing showing the simulation results obtained by changing the gap between the vibration plate 30 and the nozzle plate portion 10 in the inkjet head according to the present embodiment, and shows the flow velocity distribution of the ink around the vibration plate 30. FIG. 10(a) to (f) show flow velocity distributions when the distance d2 between the nozzle plate portion 10 and the spring portion 31 in the ejection region is set to 5 µm, 10 µm, 15 µm, 20 µm, 25 µm, and 30 µm, respectively. Other conditions are the same as those shown in FIG. 9.

As shown in FIG. 10(a) to (f), it can be seen that as the distance d2 increases, the flow rate of the ink moving from the nozzle 11 toward the outside (upward in the drawing) decreases. Further, the flow rate in the in-plane direction around the nozzle 11 and in the vicinity of the outer periphery of the base portion 31b is also reduced. However, since the distance d2 is increased, the amount of movement of the ink in the in-plane direction is increased. From the simulation results shown in FIG. 10(a) to (f), it can be seen that if the distance d2 of the ejection region is too large, a sufficient speed cannot be given to the ink ejected from the nozzle 11 to the outside, and stable droplet ejection becomes difficult.

Next, an inkjet head was manufactured, and a droplet ejection test was performed using inks having different viscosities. The structure of the inkjet head is the same as that shown in the second embodiment, and a double-supported beam structure having a beam portion 31a and a base portion 31b was used as the spring portion 31 of the vibration plate 30. The thickness of the vibration plate 30 was 75 µm, the thickness of the spacer portion 20 was 20 µm, the thickness of the nozzle plate portion 10 was 100 µm, the diameter of the nozzle 11 was 40 µm, and the weights 34 were 0.6 mm and 0.8 mm in diameter. The drive signal applied to the actuator 50 has a frequency of 100 Hz and a voltage of 240 V. As an ink sample, a standard solution for viscometer calibration JS50, JS100, and JS200 (manufactured by Nippon Grease Co., Ltd.) were used. The viscosities of the ink samples JS50, JS100, and JS200 were 35 mPa·s, 73 mPa·s, and 136 mPa·s, respectively, at a temperature of approximately 25° C., which was evaluated.

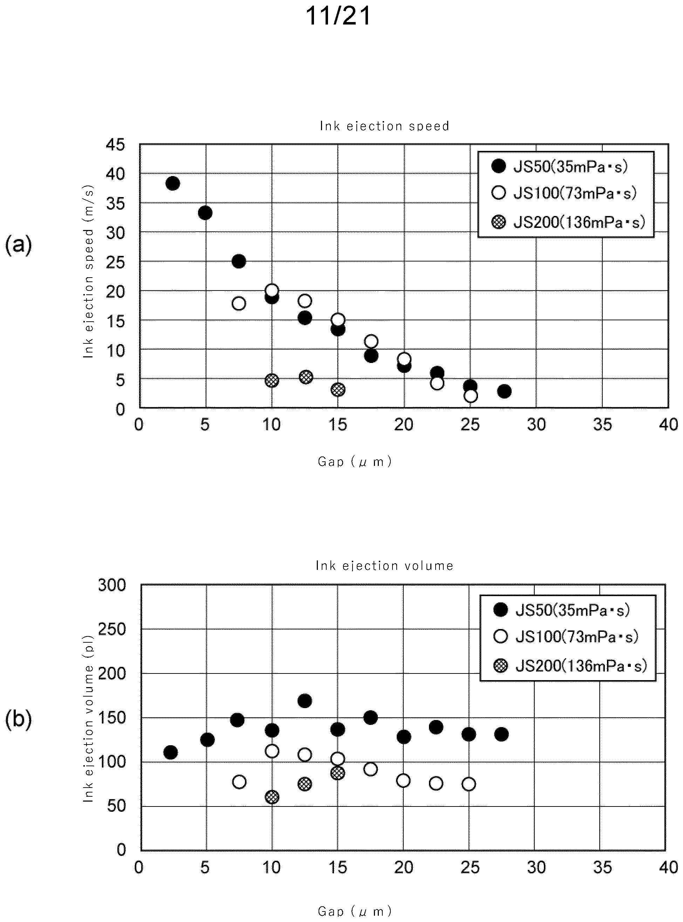

FIG. 11 is a graph showing the ink ejection results in the inkjet head according to the present embodiment, wherein FIG. 11(a) shows the ink ejection speed, and FIG. 11(b) shows the ink ejection volume. As the weight 34, a weight having a diameter of 0.6 mm was used for JS 50 and JS 100, and a weight having a diameter of 0.8 mm was used for JS 200. The horizontal axis of FIG. 11(a) and (b) shows the distance (gap) d2 between the nozzle plate portion 10 and the base portion 31b in the ejection region. The vertical axis in FIG. 11(a) shows the speed of the droplets ejected from the nozzle 11. The vertical axis in FIG. 11(b) indicates the ejection volume per droplet of the droplets ejected from the nozzle 11.

As shown in FIG. 11(a), it was confirmed that a speed larger than 0 m/s was achieved by applying an ejection speed to the ink in any of the sample inks, and that droplets could be ejected from the nozzle 11 even if an ink having a very high viscosity was used. In particular, when droplets can be ejected at a speed of 5 m/s or more from the nozzle 11, it is possible to stabilize the ejection direction of the droplets and to improve the positional accuracy of the ink application. For the sample inks JS50 and JS100, it was confirmed that droplets can be ejected from the nozzle 11 up to the region where the distance d2 is 30 µm, but in order to eject at 5 m/s or more, the distance d2 is preferably 20 µm or less. Further, as shown in FIG. 11(b), it was confirmed that the ejection volume of the ink has a small correlation with the distance d2, and that droplets having substantially the same volume could be ejected regardless of the distance d2.

In the inkjet head of the present embodiment, when the spring portion 31 of the vibration plate 30 moves in the direction of the nozzle 11, the ink between the nozzle plate portion 10 and the vibration plate 30 is compressed, and the ink in the ejection region is ejected from the nozzle 11. At the same time, in the ejection region, the ink also moves toward the outer peripheral side and flows into the reservoir region. As the distance d2 between the nozzle plate portion 10 and the spring portion 31 in the ejection region decreases, the fluid resistance in the in-plane direction between the spring portion 31 and the nozzle plate portion 10 increases, and more ink is directed toward the nozzle 11 side. This is because a large pressure is generated in the ink in the ejection region, and the pressure is allowed to escape as the ink passes through the nozzle 11.

As described above, in the present embodiment, it was confirmed that, by simulation and experiment, by setting the distance d2 in the ejection region to be in the range of 1 µm or more and 50 µm or less, and the width W or the diameter D of the base portion 31b in the ejection region to be in the range of 200 µm or more and 2 mm or less, the droplets were ejected from the nozzle 11 even if the viscosity of the ink was 20 mPa·s or more and 1 Pa·s or less. In order to eject ink having a larger viscosity, it is necessary to increase the mass of the weight 34 while increasing the d2 and W or D. In order to provide sufficient kinetic energy to the weight 34, the mass of the actuator 50 is preferably greater than the mass of the weight 34. More preferably, the mass of the actuator 50 is equal to or greater than three times the mass of the weight 34.

### (Fourth Embodiment)

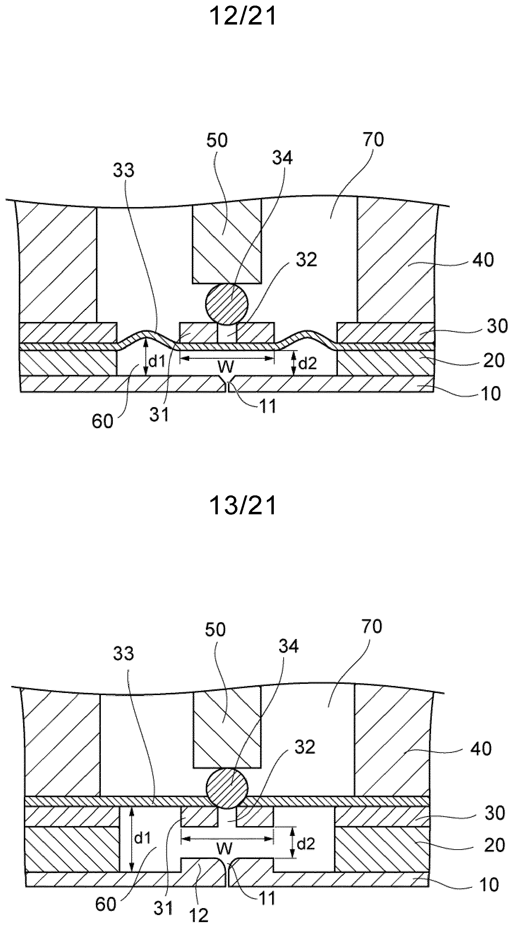

Next, a fourth embodiment of the present invention will be described. Description of contents overlapping with those of the first embodiment will be omitted. FIG. 12 is a schematic cross-sectional drawing showing the structure of the inkjet head according to the present embodiment.

As shown in FIG. 12, the inkjet head of the present embodiment comprises a nozzle plate portion 10, a spacer portion 20, a vibration plate 30, a case portion 40, an actuator 50, an ink chamber 60, and a storage space 70. In addition, a nozzle 11 is formed in the nozzle plate portion 10. Further, the vibration plate 30 comprises a spring portion 31, a positioning portion 32, and a thin plate portion 33, and a weight 34 is disposed on the positioning portion 32. Further, the thin plate portion 33 is disposed closer to the ink chamber 60 than the spring portion 31, and is bent and bulged toward the storage space 70 in the reservoir region of the ink chamber 60. In the ink chamber 60, the distance d1 between the thin plate portion 33 and the nozzle plate portion 10 at the position where the bulge of the thin plate portion 33 is maximized is larger than the distance d2 between the spring portion 31 and the nozzle plate portion 10 in the ejection region.

In the inkjet head according to the present embodiment as well, the storage space 70 and the ink chamber 60 are separated from each other by the thin plate portion 33 of the vibration plate 30, and the actuator 50 and the weight 34 can be separated from the ink without filling the ink in the storage space 70, so that various types of ink can be used, and the degree of freedom in selecting the ink material is improved. Further, it is possible to reduce the loss of kinetic energy transmitted from the actuator 50 to the vibration plate 30 via the weight 34, and it is possible to continuously eject ink having high viscosity at a high frequency.

Further, the ink chamber 60 comprises an ejection region comprising an inlet of the nozzle 11 and a reservoir region adjacent to the ejection region, and the gap between the nozzle plate portion 10 and the vibration plate 30 is smaller in the distance d2 in the ejection region than the distance d1 in the reservoir region, so that even an ink having high viscosity, such as 20 mPa·s or more and 1 Pa s or less, can improve the speed of ejecting the droplets.

### (Fifth Embodiment)

Next, a fifth embodiment of the present invention will be described. Description of contents overlapping with those of the first embodiment will be omitted. FIG. 13 is a schematic cross-sectional drawing showing the structure of the inkjet head according to the present embodiment.

As shown in FIG. 13, the inkjet head of the present embodiment comprises a nozzle plate portion 10, a spacer portion 20, a vibration plate 30, a case portion 40, an actuator 50, an ink chamber 60, and a storage space 70. Further, a nozzle 11 is formed in the nozzle plate portion 10, and a protruding portion 12 protruding into the ink chamber 60 more than the other region is formed around the nozzle 11. Further, the vibration plate 30 comprises a spring portion 31, a positioning portion 32, and a thin plate portion 33, and a weight 34 is disposed on the positioning portion 32. In the ink chamber 60, a distance d1 between the thin plate portion 33 and the nozzle plate portion 10 in the reservoir region is larger than a distance d2 between the spring portion 31 and the protruding portion 12 in the ejection region.

FIG. 13 shows an example in which the protruding portion 12 is protruded with the same width W as the spring portion 31, but the protruding portion 12 may be formed with a width different from that of the spring portion 31. Further, although a shape having a flat top surface is shown as the protruding portion 12, the protruding portion 12 may be formed of a curved surface, an inclined surface, a multi-stage surface, or the like.

In the inkjet head according to the present embodiment as well, the storage space 70 and the ink chamber 60 are separated from each other by the thin plate portion 33 of the vibration plate 30, and the actuator 50 and the weight 34 can be separated from the ink without filling the ink in the storage space 70, so that various types of ink can be used, and the degree of freedom in selecting the ink material is improved. Further, it is possible to reduce the loss of kinetic energy transmitted from the actuator 50 to the vibration plate 30 via the weight 34, and it is possible to continuously eject ink having high viscosity at a high frequency.

Further, the ink chamber 60 comprises an ejection region comprising an inlet of the nozzle 11 and a reservoir region adjacent to the ejection region, and the gap between the nozzle plate portion 10 and the vibration plate 30 is smaller in the distance d2 in the ejection region than the distance d1 in the reservoir region, so that even an ink having high viscosity, such as 20 mPa·s or more and 1 Pa s or less, can improve the speed of ejecting the droplets.

### (6th embodiment)

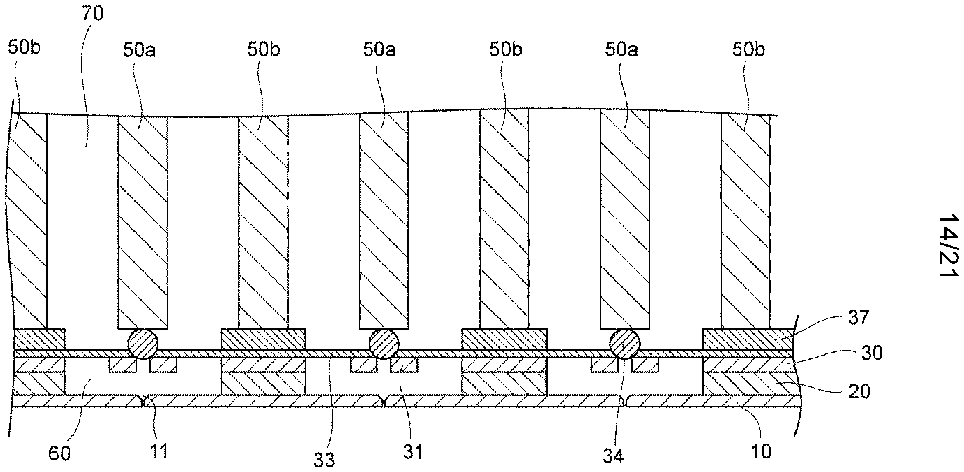

Next, a sixth embodiment of the present invention will be described. Description of contents overlapping with those of the first embodiment will be omitted. FIG. 14 is a schematic cross-sectional drawing showing the structure of the inkjet head according to the present embodiment. The present embodiment is a modification of the second embodiment.

As shown in FIG. 14, the inkjet head of the present embodiment comprises a nozzle plate portion 10, a spacer portion 20, a vibration plate 30, a case portion 40, actuators 50a and 50b, an ink chamber 60, and a storage space 70. A plurality of nozzles 11 are formed in the nozzle plate portion 10, and a spring portion 31, a thin plate portion 33, and a weight 34 are disposed at positions corresponding to the respective nozzles 11. Further, between the adjacent nozzles 11, a spacer portion 20, a vibration plate 30, and an adjusting portion 37 are arranged, and an ink chamber 60 is formed for each nozzle 11.

The adjusting portion 37 is provided closer to the storage space 70 than the vibration plate 30 in the region in which the spacer portion 20 is formed, and is a member that adjusts the height of the surface in contact with the actuator 50b. The contact surface between the adjusting portion 37 and the vibration plate 30 is fixed by an adhesive. As shown in FIG. 14, the height of the upper surface of the adjusting portion 37 is set to be substantially equal to the height of the position at which the weight 34 and the actuator 50a contact each other. In order for the tip ends of the adjusting portion 37 and the actuator 50b to reliably contact each other regardless of the producing error, it is preferable that the upper surface of the adjusting portion 37 is positioned slightly higher than the tip end of the actuator 50a. The tip of the actuator 50b is in contact with the upper surface of the adjusting portion 37 and fixed by an adhesive.

The actuators 50a and 50b are comb-shaped portions provided on the actuator 50 formed of a piezoelectric material, and the actuators 50a and 50b are alternately formed. As shown in FIG. 14, the tip of the actuator 50a is in contact with the weight 34, and the tip of the actuator 50b is fixed by an adhesive in contact with the upper surface of the adjusting portion 37. The actuator 50a corresponds to the actuator in the present application because a voltage is applied by a drive signal to perform an expansion and contraction operation, and kinetic energy is transferred to the weight 34. The actuator 50b is not applied with a drive signal and is a non-drive portion, and corresponds to the support member in the present invention because the actuator 50b holds the vibration plate 30, the spacer portion 20, and the nozzle plate portion 10 via the adjustment portion 37.

In the inkjet head shown in FIG. 14, a laminated structure of the spacer portion 20, the vibration plate 30, and the adjusting portion 37 is constituted between the plurality of actuators 50a, and the laminated structure is held by the actuator 50b which is a non-driving portion of the actuator 50. Thus, it is possible to suppress deformation of the spring portion 31 in the adjacent ink chamber 60 by the expansion and contraction operation of the actuator 50a, and to improve the control accuracy of the droplet ejection in each ink chamber 60.

In FIG. 14, an example is shown in which the adjusting portion 37 is formed separately from the vibration plate 30, but the vibration plate 30 and the adjusting portion 37 may be integrally formed by increasing the thickness of the vibration plate 30 in the region where the actuator 50b faces. Alternatively, the thin plate portion 33 and the adjusting portion 37 may be integrally formed by extending the thin plate portion 33 to the region of the actuator 50b and increasing the thickness of the thin plate portion 33 in the region facing the actuator 50b.

As described above, in the inkjet head of the present embodiment, the laminated structure comprising the spacer portion 20 is provided between the plurality of adjacent actuators 50a, and the laminated structure comprising the spacer portion 20 is held by the actuator 50b which is the non-driving portion of the actuator 50, so that the control accuracy of the droplet ejection in each ink chamber 60 can be improved.

### (7 Embodiment)

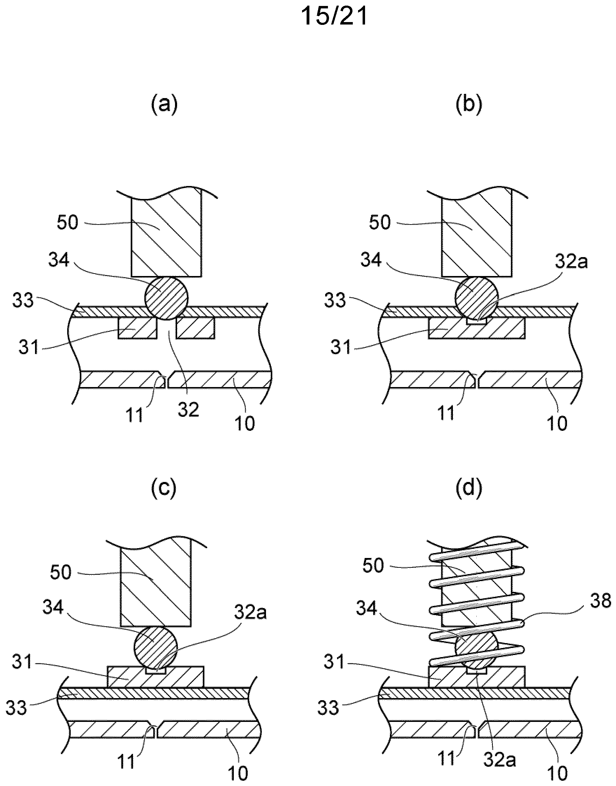

Next, a seventh embodiment of the present invention will be described. Description of contents overlapping with those of the first embodiment will be omitted. FIG. 15 is a schematic cross-sectional drawing showing the structure of the inkjet head according to the present embodiment.

The structure shown in FIG. 15(a) is a modification of the first embodiment. In the first embodiment, a flexible sheet-shaped member is used as the thin plate portion 33, but an elastically deformable metal sheet-shaped member may be used as the thin plate portion 33. In addition, in the first embodiment, the spring portion 31 and the thin plate portion 33 are separately formed, but they may be integrally formed of the same material.

The structure shown in FIG. 15(b) is a modification of the first embodiment. In the first embodiment, the positioning portion 32 of the through hole is formed in the spring portion 31, but the positioning portion 32a having a concave shape may be formed on the storage space 70 side of the spring portion 31. Since the positioning portion 32a is concave in shape and does not penetrate from the storage space 70 to the ink chamber 60, it is unnecessary to seal the ink leakage prevention by the adhesive at the opening of the thin plate portion 33.

The structure shown in FIG. 15(c) is a modification of FIG. 15(b). In this modification, by forming the concave-shaped positioning portion 32a on the spring portion 31 and disposing the thin plate portion 33 closer to the ink chamber 60 than the spring portion 31, it is not necessary to form an opening at a position corresponding to the positioning portion 32a of the thin plate portion 33, so that the ink chamber 60 and the storage space 70 can be easily isolated from each other.

The structure shown in FIG. 15(d) is a modification of FIG. 15(c). In the second embodiment, a double-supported beam structure in which the beam portion 31a is extended from both sides of the base portion 31b is used as the structure of the spring portion 31, but a structure in which the base portion 31b of the spring portion 31 is held by the coil spring 38 may be used.

The present invention is not limited to the above-described embodiments, and various modifications can be made within the scope of the claims, and the embodiments obtained by appropriately combining the technical means disclosed in the different embodiments are also included in the technical scope of the present invention. The actuator can utilize a laminated piezoelectric body. By using the laminated piezoelectric body, the driving voltage can be lowered.

### (8th embodiment)

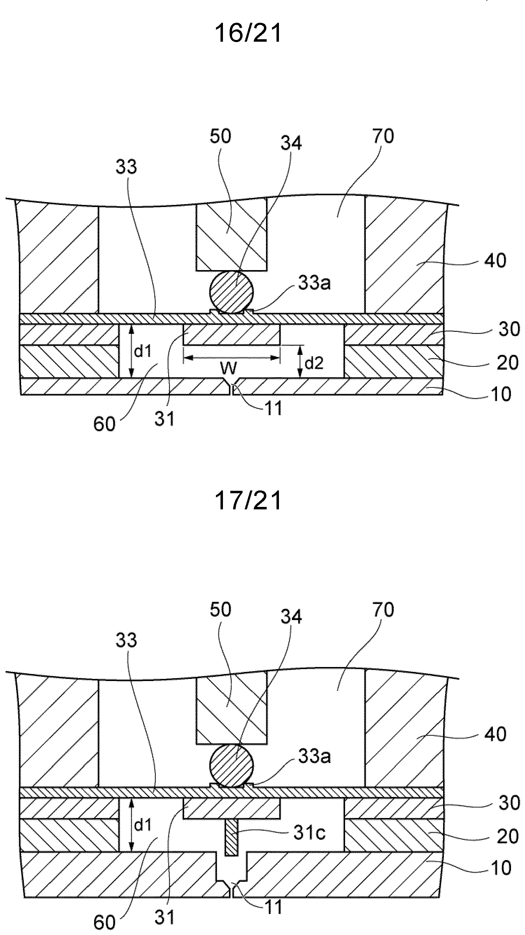

Next, an eighth embodiment of the present invention will be described. Description of contents overlapping with those of the first embodiment will be omitted. FIG. 16 is a schematic cross-sectional drawing showing the structure of the inkjet head according to the present embodiment.

The structure shown in FIG. 16 is a modification of the first embodiment. In the first embodiment, the vibration plate 30 comprises a spring portion 31, a positioning portion 32 which is a hole formed in the spring portion 31, and a thin plate portion 33, and a weight 34 is disposed on the positioning portion 32. On the other hand, in the present embodiment, the thin plate portion 33 has the base portion 33a on the main surface of the storage space 70 side, and the weight 34 is positioned on the base portion 33a.

Since the weight 34 is positioned on the base portion 33a, the spring portion 31 may not have a hole, and may have a rectangular parallelepiped cross-section as shown in FIG. 16. The thin plate portion 33 may also not have an opening, and may have a rectangular parallelepiped cross-section as shown in FIG. 16.

When the spring portion 31 is provided with a hole of the positioning portion 32, it is necessary to accurately adhere the thin plate portion 33 having an opening to the spring portion 31 having the hole, but since it is necessary to adhere the weight 34 to the circumference of the hole of the positioning portion 32 and the circumference of the opening of the thin plate portion 33, there is a possibility that ink leaks into the storage space 70 when a gap is formed between the positioning portion 32 and the thin plate portion 33, and the weight 34. Further, although it is sufficient that the adhesive is filled in the gap of the positioning portion 32 opposed to the nozzle, but if the filling of the adhesive is insufficient, a bubble pool will be formed in the gap of the positioning portion 32, which will affect the ejection characteristics. As in the present embodiment, when the thin plate portion 33 has the base portion 33a on the main surface of the storage space 70 side and the weight 34 is positioned on the base portion 33a, the hole of the spring portion 31 is not necessary, and a flat vibration plate can be used. When the vibration plate is flat, better ejection characteristics can be obtained.

The position at which the weight 34 is disposed on the vibration plate 30 needs to be a position opposed to the nozzle 11 via the vibration plate 30 in order to ensure ink ejection accuracy. By providing the base portion 33a on the thin plate portion 33 so that the weight 34 is disposed at the position opposed to the nozzle 11, the weight 34 can be accurately disposed on the vibration plate 30.

The material of the base portion 33a may be an adhesive photosensitive film resist. The photosensitive film resist having adhesion to the thin plate portion 33 is preferably disposed by pressing or thermocompression bonding.

The photosensitive film resist disposed on the thin plate portion 33 can be patterned by exposure and development to form a base portion 33a having a desired shape. The photosensitive film resist having adhesion is not particularly limited, and for example, a photosensitive adhesive material in the form of a film manufactured by Tokyo Ohka Kogyo Co., Ltd. can be used. Since the photosensitive adhesive material has a film shape having a predetermined thickness and has adhesiveness, it can be adhered to the thin plate portion 33 with high thickness accuracy, and by post-baking after the adhesion, the base portion 33a can be easily coupled to the thin plate portion 33.

### (9th embodiment)

Next, a ninth embodiment of the present invention will be described. Description of contents overlapping with those of the first embodiment will be omitted. FIG. 17 is a schematic cross-sectional drawing showing the structure of the inkjet head according to the present embodiment. The present embodiment is a modification of the eighth embodiment.

The spring portion 31 has a projection portion 31c on the main surface on the nozzle 11 side so as to face the inlet of the nozzle 11, and the projection portion 31c is configured to be insertable with a gap at the inlet of the nozzle 11. The projection portion 31c may be inserted with a gap at the inlet of the nozzle 11 when the actuator 50 is driven, and may be inserted with a gap at the inlet of the nozzle 11 before and during the driving of the actuator 50, but is preferably inserted with a gap at the inlet of the nozzle 11 before and during the driving of the actuator 50.

By providing the spring portion 31 with the projection portion 31c, it is possible to prevent air from accumulating on the inlet side of the nozzle 11 in the nozzle plate portion 10. Further, as the distance d2 between the nozzle plate portion 10 and the spring portion 31 decreases, the ink can be easily fed into the nozzle 11, and escape of the ink to the reservoir region can be suppressed. Further, it is possible to accurately control the fluid resistance of the ink by the gap (gap of the double cylinder) between the side wall of the projection portion 31c and the side wall of the inlet of the nozzle 11. The gap between the side wall of the projection portion 31c and the side wall of the inlet of the nozzle 11 (the gap of the double cylinder) is preferably 5 to 20 µm before the actuator is driven, preferably before and during the drive. By having the gap in the preferable range, it is possible to accurately control the fluid resistance of the ink while preventing the foreign matter from being caught in the gap.

### (10th embodiment)

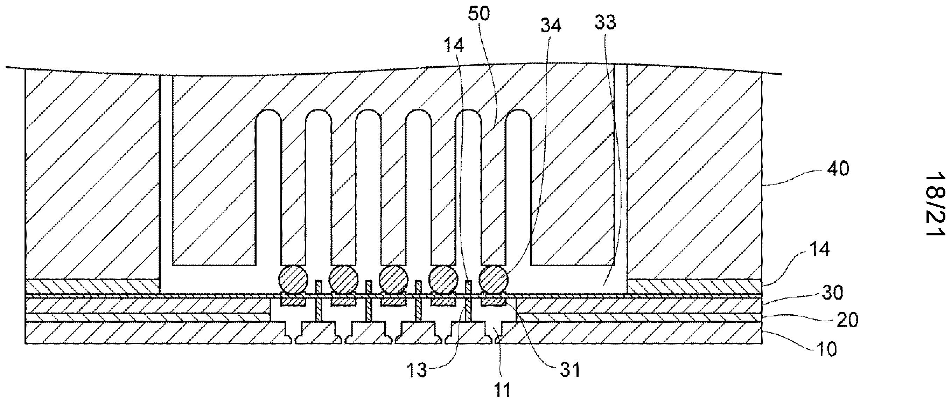

Next, a tenth embodiment of the present invention will be described. Description of contents overlapping with those of the first embodiment will be omitted. FIG. 18 is a schematic cross-sectional drawing showing the structure of the inkjet head according to the present embodiment. The present embodiment is a modification of the second embodiment.

As shown in FIG. 18, the inkjet head of the present embodiment comprises a nozzle plate portion 10, a spacer portion 20, a vibration plate 30, a beam 14, a case portion 40, an actuator 50, an ink chamber, and a storage space. A plurality of nozzles 11 are formed in the nozzle plate portion 10, and a spring portion 31, a thin plate portion 33, and a weight 34 are disposed at positions corresponding to the respective nozzles 11.

The vibration plate 30 has a beam 14 on the main surface of the thin plate portion 33 on the side of the storage space, a pillar 13 is provided on the main surface of the thin plate portion 33 on the side of the ink chamber 60, the beam 14 and the pillar 13 are bonded to the thin plate portion 33 between the plurality of adjacent weights 34 and opposed to each other with the thin plate portion 33 interposed therebetween, and the pillar 13 is also bonded to the nozzle plate portion 10.

When a plurality of actuators are simultaneously driven, a large pressure is generated between the vibration plate 30 and the nozzle plate portion 10, and the nozzle plate portion 10 deflects and the nozzle 11 escapes in the ejection direction, and a part of the energy for pushing the vibration plate 30 via the weight 34 by using the actuator 50 is lost. On the other hand, the vibration plate 30 may have the pillar 13 that is also bonded to the nozzle plate portion 10 and the beam 14 opposed to the pillar 13 with the thin plate portion 33 interposed therebetween, thereby increasing the rigidity of the nozzle plate portion 10.

The pillar 13 may have a laminated structure in which a side bonded to the vibration plate 30 is composed of the same member as the vibration plate 30, and a side bonded to the nozzle plate portion 10 is composed of the same member as the spacer portion 20. The pillar 13 may be formed of the same material as the vibration plate 30 and the spacer portion 20, or may be formed of different materials.

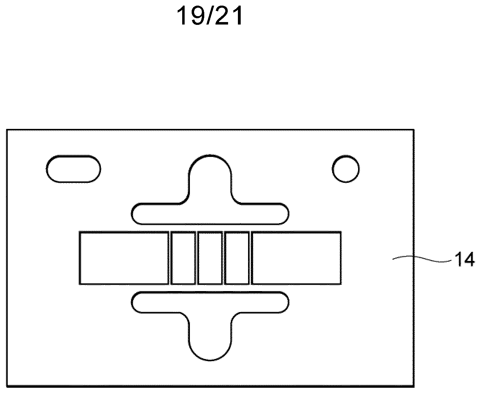

The beam 14 can be formed by laminating and bonding a plate constituting the beam 14 as shown in FIG. 19 to the thin plate portion 33. The height of the beam 14 can be adjusted by the thickness of the plate constituting the beam 14. The larger the height of the beam 14, the greater the effect of improving the rigidity of the nozzle plate portion 10, so that it is preferable that the height of the beam 14 may be, for example, 300 µm or more, or the height of the weight 34 or more.

### (11th embodiment)

Next, an eleventh embodiment of the present invention will be described. Description of contents overlapping with those of the first embodiment will be omitted. In the present embodiment, the spacer portion 20 is composed of a cured product of a photosensitive film resist fixed to the nozzle plate portion 10 and the vibration plate 30.

Since the gap between the nozzle plate portion 10 and the vibration plate 30 affects the ejection characteristics including the ejection speed, the ejection volume, and the ejection direction of the ink, it is necessary to configure the ejection characteristic with high accuracy. However, since the gap is narrow, when the spacer portion 20, the nozzle plate portion 10, and the vibration plate 30 are fixed using an adhesive, the gap may change due to the influence of the thickness of the adhesive.

By using an adhesive photosensitive film resist as a material for the spacer portion 20, it is possible to fix the nozzle plate portion 10, the vibration plate 30, and the spacer portion 20 without using an adhesive. Since no adhesive is included between the nozzle plate portion 10 and the vibration plate 30, and the spacer portion 20, the gap between the nozzle plate portion 10 and the vibration plate 30 can be accurately configured. Further, since the resist is a film type dry resist, the resist can be easily arranged uniformly on the nozzle plate portion provided with the nozzle or on the vibration plate.

The formation of the laminated structure of the nozzle plate portion 10, the spacer portion 20, and the vibration plate 30 using the photosensitive film resist having adhesiveness can be performed by the following method : disposing the photosensitive film resist having adhesiveness on the nozzle plate portion or the vibration plate, exposing and developing the photosensitive film resist to pattern the photosensitive film resist, disposing the vibration plate or the nozzle plate portion on the patterned photosensitive film resist, post-baking the laminate comprising the nozzle plate portion, the photosensitive film resist, and the vibration plate to cure the photosensitive film resist to form the spacer portion to form the laminate in which the nozzle plate portion and the vibration plate are coupled with the spacer portion interposed therebetween.

The arrangement of the photosensitive film resist having adhesiveness on the nozzle plate portion or the vibration plate is preferably performed by pressing or thermocompression bonding. It is preferable to dispose the vibration plate or the nozzle plate portion on the patterned photosensitive film resist by pressing or thermocompression bonding.

The patterning is performed by exposing and developing an adhesive photosensitive film resist to form an opening. The photosensitive film resist having adhesiveness is not particularly limited, and for example, a photosensitive adhesive material (photosensitive permanent film TMMF NS-1020) in the form of a film manufactured by Tokyo Ohka Kogyo Co., Ltd. can be used. Since the photosensitive adhesive material has a film shape having a predetermined thickness and has adhesiveness, it can be bonded between the nozzle plate portion and the vibration plate with high thickness accuracy, and by post-baking after the bonding, the nozzle plate portion and the vibration plate can be easily coupled to the spacer portion therebetween.

### (12th embodiment)

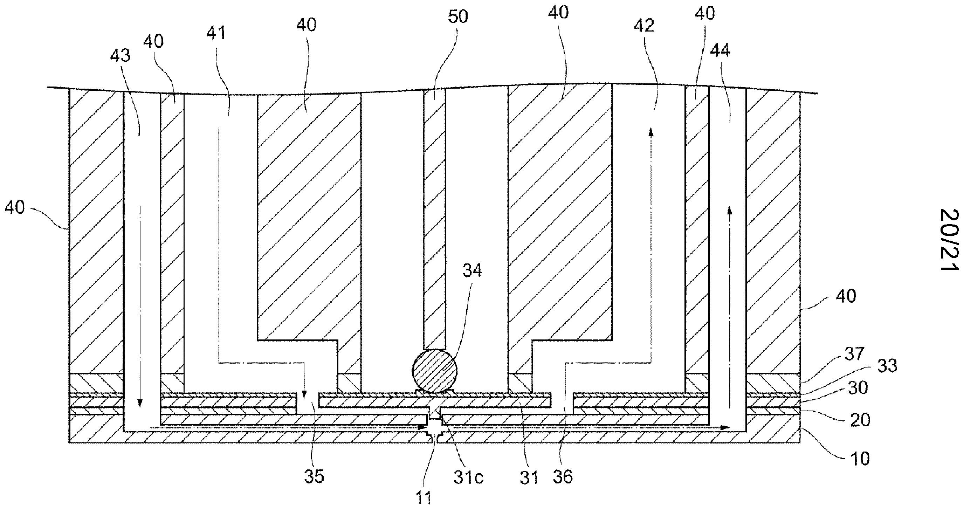

Next, a twelfth embodiment of the present invention will be described. Description of contents overlapping with those of the first embodiment will be omitted. FIG. 20 is a schematic cross-sectional drawing showing the structure of the inkjet head according to the present embodiment. This embodiment is a modification of FIG. 3 shown in the first embodiment.

FIG. 20 is a schematic cross-sectional drawing showing the ink flow path in the inkjet head according to the present embodiment and the air discharge flow path branched from the nozzle, and shows a state before the ink ejection. As shown in FIG. 20, ink flow paths 41 and 42 are formed in the case portion 40. In the vibration plate 30, an ink supply hole 35 and an ink discharge hole 36 are formed at positions corresponding to the ink flow paths 41 and 42. An air discharge flow path 44 branched from the nozzle 11 is formed in the case portion 40 and the nozzle plate portion 10. The air discharge flow path may comprise only the air discharge flow path 44 on one side of the nozzle 11, or may comprise the air discharge flow paths 43 and 44 on both sides of the nozzle 11. This air discharge flow path makes it difficult for air to be drawn from the nozzle 11 side, and it is possible to quickly discharge air even if air is drawn in. In addition, from the viewpoint of making the ink ejection direction as coincide with the nozzle axis as much as possible, it is preferable to provide the air discharge flow paths 43 and 44 on both sides of the nozzle 11. The air discharge flow paths 43 and 44 suppress the deviation of the pressure in the nozzle 11 at the time of ejection. Further, by gently flowing ink from one of the air discharge flow paths 43 and 44 to the other, it is possible to promote discharge of air and to suppress change in ink physical properties of the nozzle portion.

When the inlet side of the nozzle 11 has a relatively large space, air tends to stay in the space and affect the ejection characteristics of the ink. In particular, when the thickness of the nozzle plate portion 10 is larger than the distance d2 in order to increase the rigidity of the nozzle plate portion 10, a large space is formed on the inlet side of the nozzle in the nozzle plate portion with respect to the narrow distance d2, and air is easily retained in the space. By providing the air discharge flow path 44, air can be discharged, so that it is possible to suppress accumulation of air in the space on the inlet side of the nozzle 11.

It is also possible to suck air from the nozzle outlet, but when sucking air from the nozzle outlet, it is necessary to stop printing and to attach a suction cap to the nozzle 11 to suck air, which is complicated. Since the inkjet head is provided with the air discharge flow path 44, it is not necessary to stop printing, and it is not necessary to attach a suction cap to the nozzle 11.

The air discharge flow path 44 can also discharge ink together with air, and can collect the discharged ink. The collected ink is degassed and reused by the degassing device incorporated in the circulation system, and is supplied to the ink flow path 41 and/or the air discharge flow path 43.

When the air discharge flow path 44 is provided, the flow path is relatively narrowed so that the fluid resistance of the air discharge flow path 44 is higher than the fluid resistance of the nozzle 11 so as not to substantially affect the ejection characteristics of the ink ejected from the nozzle 11. The fluid impedance of the air discharge flow path 44 is preferably 5 to 30 times, more preferably 7 to 20 times, and still more preferably 9 to 15 times the fluid impedance of the nozzle 11. The same applies to the preferred fluid impedance of the air discharge flow path 43.

### (13th embodiment)

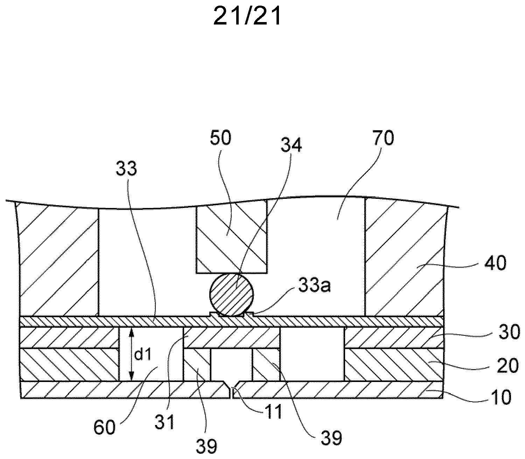

Next, a thirteenth embodiment of the present invention will be described. Description of contents overlapping with those of the first embodiment will be omitted. FIG. 21 is a schematic cross-sectional drawing showing the structure of the inkjet head according to the present embodiment. The present embodiment is a modification of the eleventh embodiment.

In forming the nozzle plate portion 10, the spacer portion 20, and the vibration plate 30 using the photosensitive film resist having adhesiveness in the eleventh embodiment, a temporary determination portion 39 that defines the distance d2 between the nozzle plate portion 10 and the vibration plate 30 may be provided between the nozzle plate portion 10 and the vibration plate 30. The actuator 50 and the weight 34 are disposed on the vibration plate 30, and the temporary determination portion 39 is removed after assembling the inkjet head. The after assembling the inkjet head means a state in which, in a state in which the inkjet head is not driven, the weight 34 is held at a position where the weight 34 abuts on the actuator 50 and is biased in the direction of the ink chamber 60 at the tip of the actuator 50 to maintain the balance against the restoring force generated by the spring portion 31.

The distance d2 has a large influence on the ejection characteristics of the ink, and it is required to form the distance d2 corresponding to each nozzle with small variation and high accuracy. When the vibration plate 30 is laminated after the temporary determination portion 39 is formed, it is possible to reduce the influence on the distance d2 due to the deflection of the vibration plate 30 and the deformation of the vibration plate 30 itself. Therefore, by removing the temporary determination portion 39 after the case portion 40 positions and holds the actuator 50, the distance d2 between the nozzle plate portion 10 and the vibration plate 30 can be accurately formed.

The formation position of the temporary determination portion 39 is not particularly limited as long as the distance d2 between the nozzle plate portion 10 and the vibration plate 30 can be secured, and may be disposed on the entire surface of the portion other than the spacer portion 20, or may be partially disposed at a position where the nozzle plate portion 10 and the vibration plate 30 face each other.

The temporary determination portion 39 may be formed of a soluble photoresist. The soluble photoresist can be easily removed by pouring a resist removing agent after assembly of the inkjet head. The soluble photoresist may be a dry film resist conventionally used. As for removing the dry film resist, a conventionally used stripping solution can be used, and for example, a stripping solution RS-091 manufactured by JCU Corporation may be used.

The height of the temporary determination portion 39 is preferably smaller than the height of the spacer portion 20. When a plurality of weights 34 are used, the plurality of weights 34 may have dimensional variation, but by making the height of the temporary determination portion 39 smaller than the height of the spacer portion 20, even when the plurality of weights 34 have dimensional variation, the distance d2 before driving can be made the same. The height of the temporary determination portion 39 is preferably 10 to 30% smaller than the height of the spacer portion 20 although the dimensional variation of the plurality of weights 34.

The present disclosure is also directed to the inkjet head and a printing device comprising a drive control unit that drives the inkjet head. The printing device can be used for printing various inks, and can be suitably used for printing high-viscosity inks in particular.

The present disclosure is also directed to a method for producing a semiconductor device, comprising: printing a solvent-free ink using the printing device described above to mount a semiconductor on a substrate. Examples of the solvent-free ink include UV curable inks and solid inks. The solid ink that is in a solid state at room temperature melts when heated, and is used as a liquid, and examples thereof include wax. According to the printing device, it is possible to suitably print a high-viscosity ink, and it is possible to suitably print a solvent-free ink used for mounting a semiconductor. The solvent-free ink is used in mounting a semiconductor on a substrate, such as underfill, adhesion, or hole filling. According to the present producing method, since a solvent-free ink having high viscosity can be favorably printed, mounting of a semiconductor on a substrate can be easily performed.

### [REFERENCE SIGNS LIST]

- 10: nozzle plate portion
- 20: spacer portion
- 30: vibration plate
- 40: case portion
- 50, 50a, 50b: actuator
- 60: ink chamber
- 70: storage space
- 80: flexible cable
- 11: nozzle
- 12: protruding portion
- 13: pillar
- 14: beam
- 21: opening portion
- 22: cut portion
- 23: tongue-shaped portion
- 31: spring portion
- 31a: beam portion
- 31b: base portion
- 31c: projection portion
- 32, 32a: positioning portion
- 33: thin plate portion
- 33a: base portion on the thin plate portion
- 34: weight
- 35: ink supply hole
- 36: ink discharge hole
- 37: adjusting portion
- 38: coil spring
- 39: temporary determination portion
- 41, 42: ink flow path
- 43, 44: air discharge flow path
- 51: actuator substrate

## Claims

1. An inkjet head **characterized in that** the inkjet head comprises a nozzle plate portion on which a nozzle for ejecting droplets is formed, a vibration plate disposed opposite to an inlet of the nozzle, a weight disposed in contact with the vibration plate, and an actuator in contact with the weight, wherein the actuator is driven by a drive signal to fly the weight to eject ink in the ink chamber formed between the nozzle plate portion and the vibration plate from the nozzle, and
wherein a storage space in which the actuator is disposed is configured to be separated from the ink chamber by the vibration plate.

2. The inkjet head according to claim 1,
wherein the ink chamber comprises an ejection region comprising the inlet of the nozzle, and a reservoir region adjacent to the ejection region, and
a gap between the nozzle plate portion and the vibration plate is smaller in the ejection region than in the reservoir region.

3. The inkjet head according to claim 2,
wherein the gap in the ejection region is in a range of 1 µm or more to 50 µm or less.

4. The inkjet head according to any one of claims 1 to 3,
wherein viscosity of the ink is in a range of 20 mPa·s or more.

5. The inkjet head according to any one of claims 1 to 4,
wherein the vibration plate is composed of a laminated structure of a beam-shaped spring portion and a thin plate portion, and the thin plate portion is composed of a flexible sheet.

6. The inkjet head according to claim 5,
wherein a portion of the spring portion facing the inlet of the nozzle is formed to be wide.

7. The inkjet head according to claim 5 or 6,
wherein the weight is spherical in shape, and the weight is fitted and positioned in a positioning portion provided in the spring portion.

8. The inkjet head according to claim 5 or 6,
wherein the weight is spherical in shape and the weight is positioned on a base provided on a main surface of the thin plate portion on the storage space side.

9. The inkjet head according to claim 8,
wherein the spring portion comprises a projection portion on a main surface of the nozzle side so as to face the inlet of the nozzle, and the projection portion is configured to be insertable with a gap into the inlet of the nozzle.

10. The inkjet head according to any one of claims 1 to 9,
wherein an ink supply hole is formed through the vibration plate, and the ink is supplied to the ink chamber via the ink supply hole.

11. The inkjet head according to any one of claims 1 to 10, comprising a plurality of combinations of the actuator and the weight, and a spacer portion disposed between the nozzle plate portion and the vibration plate, wherein the spacer portion is provided between the plurality of adjacent actuators.

12. The inkjet head according to claim 11, comprising a support member for supporting the nozzle plate portion,
wherein the support member is fixed to a laminated structure comprising the nozzle plate portion, the spacer portion, and the vibration plate.

13. The inkjet head according to claim 12,
wherein the support member is a non-driving portion integrally formed with the actuator.

14. The inkjet head according to any one of claims 5 to 9, comprising a plurality of combinations of the actuator and the weight, and a spacer portion disposed between the nozzle plate portion and the vibration plate,
wherein the vibration plate comprises a beam on a main surface of the thin plate portion on the storage space side, and a pillar on a main surface of the thin plate portion on the ink chamber side,
the beam and the pillar are bonded to the thin plate portion between the plurality of adjacent weights and opposite each other with the thin plate portion interposed therebetween, and
the pillar is also bonded to the nozzle plate portion.

15. The inkjet head according to any one of claims 11 to 14,
wherein the spacer portion is composed of a cured product of a photosensitive film resist fixed to the nozzle plate portion and the vibration plate.

16. The inkjet head according to any one of claims 1 to 15,
wherein the nozzle plate portion comprises a discharge flow path for the ink branched from the nozzle in the nozzle plate portion.

17. A printing device comprising the inkjet head according to any one of claims 1 to 16 and a drive control unit driving the inkjet head.

18. A method for producing a semiconductor device, wherein a semiconductor is mounted on a substrate by printing a solvent-free ink using the printing device according to claim 17.

19. A method for producing the inkjet head according to any one of claims 9 to 15, comprising
disposing a photosensitive film resist having adhesiveness on the nozzle plate portion or the vibration plate,
exposing and developing the photosensitive film resist to pattern the photosensitive film resist,
disposing the vibration plate or the nozzle plate portion on the patterned photosensitive film resist, and
post-baking a laminate comprising the nozzle plate portion, the photosensitive film resist, and the vibration plate to cure the photosensitive film resist to form the spacer portion to form a laminate in which the nozzle plate portion and the vibration plate are coupled with the spacer portion interposed therebetween.

20. The method for producing the inkjet head according to claim 19, comprising
providing a temporary determination portion defining the gap between the nozzle plate portion and the vibration plate between the nozzle plate portion and the vibration plate, and
removing the temporary determination portion after the inkjet head is assembled by disposing the actuator and the weight on the vibration plate.
